# EUROPÄISCHE PATENTSCHRIFT

(11) **EP 0 508 061 B1**
(45) Veröffentlichungstag und Bekanntmachung des Hinweises auf die Patenterteilung: **03.09.1997**
(21) Anmeldenummer: 92102279.4
(22) Anmeldetag: 11.02.1992
(51) Int. Cl.: G06F 11/26, H03K 17/62

(54) **Schaltungsanordnung zum Testen integrierter Schaltungen**
Circuit arrangement for testing integrated circuits
Agencement de circuit pour le test de circuits intégrés

(30) Priorität: 06.03.1991 DE 4107172
(43) Veröffentlichungstag der Anmeldung: 14.10.1992
(73) Patentinhaber: SIEMENS AKTIENGESELLSCHAFT, 80333 München (DE)
(72) Erfinder: Hölzle, Josef, Dipl.-Ing., W-8939 Bad Wörishofen (DE)

(56) Entgegenhaltungen:
- EP-A- 0 334 545
- DD-A- 262 924
- IBM TECHNICAL DISCLOSURE BULLETIN Bd. 32, Nr. 9A, Februar 1990, ARMONK, NY, USA Seiten 196 - 203 , XP000083040 'L3 LSSD LATCH ARRANGEMENT SCHEMES WHICH PERMIT 100% CACHE ARRAY LSSD TESTING'
- PATENT ABSTRACTS OF JAPAN vol. 013, no. 058 (E-714)9. Februar 1989 & JP-A-63 246 920
- INTERNATIONAL JOURNAL OF ELECTRONICS Bd. 69, Nr. 2, August 1990, LONDON, GB Seiten 225 - 231 , XP000148311;P.K. LALA ET AL.:'PARTITIONING OF LOGIC CIRCUITS FOR EXHAUSTIVE TESTING'
- ELECTRONIC DESIGN Bd. 20, Nr. 20, 28. September 1972, USA Seiten 76 - 77,D.H. SAWIN:'Use the wired-AND and implied-OR configurations to simplify logic circuitry'

## Beschreibung

Die Erfindung betrifft eine Schaltungsanordnung zum Testen von Funktionseinheiten in digitalen Schaltungen durch Prüfsignale gemäß dem Oberbegriff des Anspruchs 1.

Während der Entwurfsphase integrierter digitaler Schaltungen wird das logische Verhalten der Schaltung mit Hilfe von Softwareprogrammen simuliert. Es wird überprüft, ob die aus logischen Grundelementen wie z.B. UND- oder ODER-Schaltstufen, Zählern, bistabilen Kippstufen aufgebaute Schaltung das gewünschte logische Ergebnis liefert.

Die auf diese Weise gefundene Schaltungsanordnung wird nun als integrierte Schaltung hergestellt. Dabei wird jede einzelne integrierte Schaltung auf ihre Funktionsfähigkeit hin getestet, um Produktionsfehler soweit wie möglich zu erkennen. Dieser Test wird so durchgeführt, daß die Schaltung mit einem Testautomaten verbunden wird, der eine bestimmte Folge von Testsignalen an die Eingänge der integrierten Schaltung anlegt und die Antwort der Schaltung auf diese Testsignale mit dem vorausberechneten Ergebnis vergleicht, das sich bei korrekter Funktionsweise ergeben würde.

Das Problem bei der Bestimmung der Testsignale besteht darin, daß Funktionseinheiten im Inneren des IC's meist nicht direkt mit den Eingangssignalanschlüssen verbunden sind. Diese bleiben dann entweder praktisch untestbar, oder die Folge der Testsignale wird recht lang und deren Erstellung für den Entwicklungsingenieur zunehmend schwieriger.

Durch einen prüffreundlichen Entwurf der integrierten Schaltung, d.h. unter Hinzufügung von weiterem Schaltungsaufwand, wurde eine Anzahl von Regeln für den Entwurf integrierter digitaler Schaltungen begründet, die deren Testbarkeit auch bei größeren tungskomplexitäten gewährleisten soll. Zu den wichtigsten Regeln für einen prüffreundlichen Schaltungsentwurf zählen:
- Rücksetzen der Speicherelemente auf einen definierten Anfangszustand,
- Herausführen von für den Test wichtigen Signalen im Inneren der Schaltung direkt an den Ausgang und
- Einführen von Multiplexern, die Signalpfade von Normal- auf Testbetrieb umschalten, um z.B. einzelne Funktionsblöcke zu isolieren und direkt mit den Signaleingangs- und Signalausgangsanschlüssen des Bausteins zu verbinden.

Weiterhin wurde die Scan Path-Methode entwickelt, um größere synchron arbeitende digitale Schaltungen systematisch zu testen.

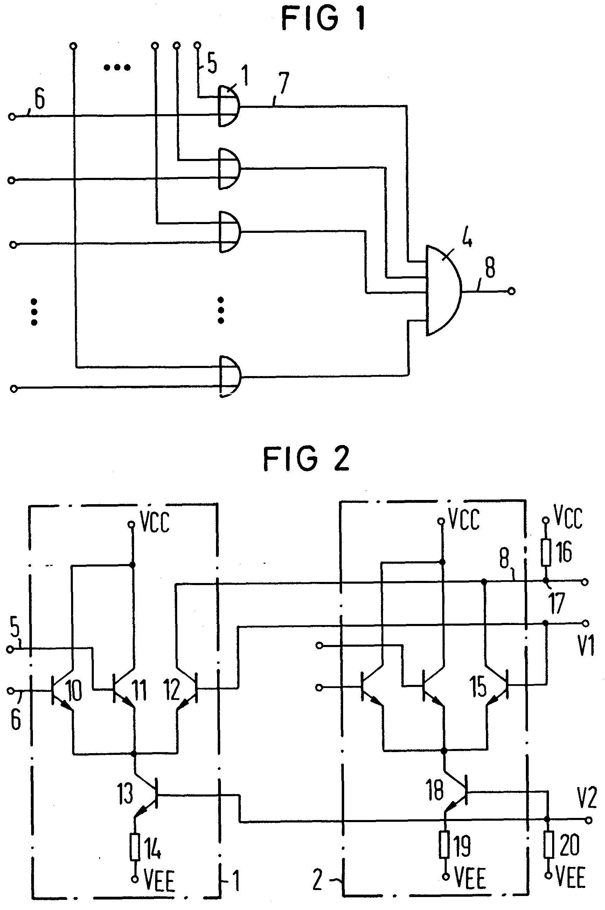

Diese Testmethode ist z.B. in der Literaturstelle "The Status of IC Design-for-Testability" von C.M. Maunder, erschienen im Journal of Semicustom ICs Band 6, No.4, 1989, Figur 2 beschrieben. Hier wird von dem allgemein bekannten Blockschaltbild für obengenannte Schaltwerke ausgegangen, bei dem taktgesteuerte Flip-Flops über eine kombinatorische Logik miteinander verbunden sind. Am Eingang jedes Flip-Flops ist ein 2:1-Multiplexer vorgesehen, mit dem zwischen zwei Signalen am Dateneingang des Flip-Flops umgeschaltet werden kann: Im Normalbetrieb ist dies ein Datensignal, das aus der kombinatorischen Logik kommt. Im Testbetrieb wird der Dateneingang eines Flip-Flops mit dem Datenausgang eines benachbarten Flip-Flops verbunden. Die Speicherelemente werden also im Testbetrieb zu einem Schieberegister verbunden. Ein Eingang des Multiplexers des ersten Flip-Flops und der Ausgang des letzten Flip-Flops des Schieberegisters werden an einen Anschluß der integrierten Schaltung gelegt. Die Steuereingänge der Multiplexer sind ebenfalls gemeinsam über einen Eingangssignalanschluß von außen zugänglich.

Eine gattungsgemäße Schaltungsanordnung ist bereits aus IBM Technical Disclosure Bulletin, Bd. 32, Nr. 9A, Februar 1990, Armonk, NY, USA, Seiten 196 - 203, ,,L3 LSSD Latch arrangement schemes which permit 100% cache array testing", insbesondere die Figuren 6 und 8, bekannt. Dort werden einer Anzahl von ODER-Schaltgliedern jeweils ein zu prüfendes Signal und Adreß-Signale zu Testzwecken zugeführt. Die Ausgänge der ODER-Schaltglieder werden in einem UND-Schaltglied verknüpft. Es wird allerdings nur das logische Schaltbild bestehend aus logischen Operatoren (UND und ODER) gezeigt. Es findet sich kein Hinweis auf eine schaltungstechnische Realisierung der Anordnung.

Eine gattungsgemäße Schaltungsanordnung ist auch in EP-A-0 334 545, insbesondere Figur 2, dargestellt. Dort ist ein einstufiger Multiplexer angegeben. Der Multiplexer enthält Transistoren für Datensignale und Transistoren für Auswahlsignale. Jeweils ein Transistor für Datensignale und ein Transistor für Auswahl signale sind miteinander zu einem differentiellen Paar verbunden. Es findet sich in EP-A-0 334 545 kein Hinweis dafür, daß die Schaltungsanordnung aus Figur 2 zum Testen von integrierten Schaltungen verwendet wird.

Die integrierte Schaltung wird nun folgendermaßen getestet: Über den Steuersignaleingang der Multiplexer werden die Flip-Flops als Schieberegister geschaltet. Dann wird über den Eingang des ersten Multiplexers eine Testsignalfolge in das Schieberegister eingelesen. Anschließend werden die Multiplexer so eingestellt, daß die Schaltung im Normalbetrieb arbeitet und somit die Antwort der kombinatorischen Logik auf die zuvor eingelesene Testsignalfolge in den Flip-Flops gespeichert wird. Beim nächsten Schritt wird wieder auf Schieberegisterbetrieb umgestellt und der Inhalt ausgelesen. Dieser Vorgang wird für alle Testsignalfolgen wiederholt. Bei der Scan-Path-Testmethode kann also die Funktion der kombinatorischen Logik nur über die Datenaus- bzw. Dateneingänge der Flip-Flops getestet werden. Es ist also insbesondere nicht möglich, etwaige für den Schaltungstest wichtige Signale im Inneren der kombinatorischen Logik direkt zu testen.

Die beschriebene Scan Path-Methode benötigt einen erhöhten Schaltungsaufwand. Er besteht in der Verwendung zusätzlicher Multiplexer am Dateneingang der Flip-Flops. Diese verlängern die Signallaufzeiten und erhöhen den Flächenverbrauch.

Der Erfindung liegt die Aufgabe zugrunde, eine Schaltungsanordnung zum Testen integrierter Schaltungen bereitzustellen, die es erlaubt, beliebige Signale der Schaltung als zu prüfende Signale auswählen zu können. Die Schaltung soll mit verhältnismäßig geringem Schaltungsaufwand in bipolarer Schaltungstechnik realisiert werden.

Gemäß der Erfindung wird diese Aufgabe dadurch gelöst, daß
- das ODER-Schaltglied mindestens drei emittergekoppelte Transistoren (10, 11, 12) enthält,
- die Emitter der ersten drei Transistoren (10, 11, 12) mit den Kollektoren eines vierten Transistors (13) verbunden sind und dessen Emitter über einen Widerstand (14) an einen Anschluß einer ersten Versorgungsspannungsquelle (VEE) angeschlossen ist,
- die Kollektoren der ersten zwei Transistoren (10, 11) mit einem Anschluß einer zweiten Versorgungsspannungsquelle (VCC) verbunden sind,
- die Basisanschlüsse der ersten zwei Transistoren (10, 11) die Eingänge des ODER-Schaltgliedes und der Kollektor des dritten Transistors (12) den Ausgang des ODER-Schaltgliedes bilden,
und daß vorzugsweise
- das UND-Schaltglied dadurch gebildet wird, daß die Kollektoren der dritten Transistoren der ODER-Schaltglieder gemeinsam über einen Widerstand (16) mit einem Anschluß der zweiten Versorgungsspannungsquelle (VCC) verbunden sind,
- die Basisanschlüsse der dritten Transistoren der ODER-Schaltglieder gemeinsam mit einem Anschluß einer dritten Versorgungsspannungsquelle (V1) verbunden sind und
- die Basisanschlüsse der vierten Transistoren der ODER-Schaltglieder gemeinsam mit einem Anschluß einer vierten Versorgungsspannungsquelle (V2) und gemeinsam über einen Widerstand (20) mit einem Anschluß der ersten Versorgungsspannungsquelle (VEE) verbunden sind.

Eine weitere Ausgestaltung bzw. Weiterbildung des Erfindungsgedankens ist Bestandteil des Anspruchs 3.

Ausführungsbeispiele der Erfindung sind in den Figuren 2 bis 3 dargestellt. Es zeigen
- FIG 1: eine bekannte, aus UND- oder ODER-Schaltgliedern aufgebaute Schaltung zum Prüfen von Signalen,
- FIG 2: die Realisierung dieser Schaltung in Stromschaltertechnik,
- FIG 3: ein Ausführungsbeispiel zum Rücksetzen von Flip-Flops.

In FIG 1 wird das Schaltungsprinzip einer Testschaltung unter Verwendung von UND- und ODER-Schaltgliedern gezeigt. Die Ausgänge mehrerer ODER-Schaltglieder mit mindestens zwei Eingängen sind mit den Eingängen eines UND-Schaltgliedes 4 verbunden. Ein Eingang jeweils eines ODER-Schaltgliedes wird mit einem zu prüfenden Signalanschluß verbunden, ein weiterer Eingang wird mit einem Auswahlsignalanschluß verbunden. Der Ausgang 8 des UND-Schaltgliedes stellt den Ausgang dieser gesamten Testschaltung dar und kann an einen Ausgangssignalanschluß der Halbleiterschaltung geführt werden.

Die Schaltung arbeitet in folgender Weise: Beispielsweise liege die Auswahlsignalleitung 6 auf L-Potential, alle anderen Auswahlsignalleitungen haben den Wert H. Somit nimmt der Ausgang 7 des ODER-Schaltgliedes 1 den Wert H an, wenn das zu prüfende Signal am Anschluß 5 H ist, und den Wert L an, wenn der Anschluß 5 auf L liegt. Die Ausgänge aller anderen ODER-Schaltglieder liegen auf H. In entsprechender Weise stellt sich am Ausgang 8 des UND-Schaltgliedes 4 der logische Wert des Prüfsignals des Anschlusses 5 ein. Es erscheint also am Ausgang 8 der Testschaltung der Wert genau jenes zu prüfenden Signals, dessen zugehöriges Auswahlsignal auf L-Potential liegt.

Die Prüfsignalanschlüsse können mit beliebigen Signalanscnlüssen innerhalb der integrierten Schaltung verbunden werden. Die Auswahlsignale können je nach Anwendungsfall auf unterschiedliche Weise erzeugt werden. Falls die integrierte Halbleiterschaltung noch entsprechend Platz für Eingangssignalanschlüsse bietet, können die Auswahlsignale von außen angelegt werden, also z.B. vom Testautomaten erzeugt werden. Es ist weiterhin denkbar, einen Zähler mit entsprechender Logikbeschaltung auf der integrierten Halbleiterschaltung vorzusehen, der die Auswahlsignale erzeugt. Dieser Zähler kann mit weiteren derartigen Testschaltungen verbunden werden, die dann parallel arbeiten. Er braucht nicht nur ausschließlich zum Testzwecke verwendet werden, sondern kann auch Teil der zu testenden Schaltung selbst sein.

Ebenso wie die eingangs angeführte Scan Path-Testmethode ist die Testschaltung aus FIG 1 in allen Schaltkreistechnologien anwendbar. Allerdings in bipolarer Stromschaltertechnik, wie ECL-(Emitter Coupled Logic) oder CML-(Current Mode Logic)Schaltungstechnik stellt sich das Problem der Verlustleistung. Die für den Schaltungstest zusätzlich benötigten Multiplexer im Scan Path-Verfahren sind stets aktiv, d.h. auch im Normalbetrieb der Schaltung. Die abzuführende Verlustleistung, die in der Regel einen für die Schaltung sehr kritischen Wert darstellt, wird erhöht. Bei Realisierung der prinzipiellen Testschaltung aus FIG 1 in Stromschaltertechnik ergibt sich eine Testschaltung, die während des Normalbetriebes der Schaltung abgeschaltet werden kann und keine Verlustleistung verbraucht.

Einen Aufbau der anhand von FIG 1 beschriebenen Testschaltung in Stromschaltertechnik zeigt FIG 2. Zur besseren Übersichtlichkeit werden nur zwei ODER-Schaltglieder 1, 2 verwendet. Das ODER-Schaltglied 1 ist in folgender Weise aufgebaut: Die Emitter von drei emittergekoppelten Transistoren 10, 11, 12 werden mit dem Kollektor eines weiteren vierten Transistors 13 verbunden, dessen Emitter über einen Widerstand 14 an einen Anschluß einer ersten Versorgungsspannungsquelle VEE angeschlossen ist. Die Kollektoren von zwei der emittergekoppelten Transistoren 10, 11 sind mit einem zweiten Versorgungspotential VCC verbunden. Ihre Basisanschlüsse stellen jeweils den Auswahlsignal- und Prüfsignalanschluß 6, 5 des ODER-Schaltgliedes 1 dar. Das weitere ODER-Schaltglied 2 ist derart parallel geschaltet, daß die Kollektoren der jeweils dritten emittergekoppelten Transistoren 12, 15 eines ODER-Schaltgliedes miteinander verbunden sind und über einen Widerstand 16 an einen Anschluß der zweiten Versorgungsspannungsquelle VCC angeschlossen sind. Am Verbindungspunkt 17 liegt das Ausgangssignal 8 an. Weiterhin sind die Basisanschlüsse der dritten Transistoren 12, 15 eines jeden ODER-Schaltgliedes gemeinsam an ein drittes Versorgungspotential V1 angeschlossen. Die Basisanschlüsse der vierten Transistoren 13, 18 sind ebenfalls gemeinsam an ein weiteres viertes Versorgungspotential V2 und gemeinsam über einen Widerstand 20 an einen Anschluß der ersten Versorgungsspannungsquelle VEE angeschlossen.

Die Transistoren 13, 18 bilden zusammen mit den emitterseitigen Widerständen 14, 19 jeweils eine Stromquelle. Nur während des Tests der integrierten Halbleiterschaltung wird die vierte sorgungsspannungsquelle V2 eingeschaltet, so daß die Transistoren 13, 18 leitend sind. Im Normalbetrieb der zu testenden Schaltung ist die vierte Versorgungsspannungsquelle V2 abgeschaltet und die Basisanschlüsse der vierten Transistoren 13, 18 sind über den Widerstand 20 mit der ersten Versorgungsspannung VEE verbunden und somit gesperrt. Der Verlustleistungsverbrauch der Schaltung in FIG 2 bleibt auf die Testdauer beschränkt.

Im folgenden soll nun das Signal, das am Anschluß 5 anliegt, getestet werden, d.h. der logische Wert des Signals am Anschluß 5 soll am Ausgang 8 erscheinen. Der Ausgang 8 ist üblicherweise mit einem Testautomaten verbunden und wird dort mit dem Wert verglichen, den man für die korrekte Funktionsweise der zu testenden Schaltung vorausberechnet hat. Eine Auswahllogik, wie sie im Zusammenhang mit FIG 1 beschrieben wurde, legt ein L-Potential an den Signaleingang 6, und sperrt den Transistor 10. Wenn das zu prüfende Signal am Anschluß 5 ebenfalls L ist, wird der Transistor 11 gesperrt. Dann leitet der Transistor 12 und ruft am Widerstand 16 einen Spannungsabfall hervor, so daß der Ausgang 8 entsprechend dem zu prüfenden Signal an Anschluß 5 ebenfalls L wird. Hat das zu prüfende Signal H-Potential, so wird der Transistor 11 leitend. Dies hat zur Folge, daß der Transistor 12 sperrt und der Ausgang 8 auf dem H-Potential VCC liegt. Gemäß den Ausführungen zu FIG 1 liegt der Auswahlsignalpegel des weiteren ODER-Schaltgliedes 2 auf H-Potential, so daß dessen Transistor 15 gesperrt ist. Deshalb wird vom ODER-Schaltglied 2 kein Spannungsabfall am Widerstand 16 hervorgerufen. Die logische Funktion, die zwischen den Signalen an den Kollektoren der Transistoren 12, 15 und dem Ausgang 8 gebildet wird, ist eine UND-Funktion. Sie kommt dadurch zustande, daß die Kollektoren dieser Transistoren verbunden werden und über einen Widerstand an die Versorgungsspannung VCC gelegt werden. Diese Schaltung wird üblicherweise als WIRED AND-Schaltung bezeichnet.

Im Vergleich zur Scan Path-Methode benötigt die Testschaltung in FIG 2 weniger Transistoren pro zu testendem Signal: Zur Realisierung eines ODER-Schaltgliedes werden vier Transistoren und ein Widerstand verwendet. Der Schaltungsaufwand pro zu prüfendem Signal für das WIRED-AND-Schaltglied, nämlich die Widerstände 16 und 20, ist vernachlässigbar gering, wenn beispielsweise 64 ODER-Schaltglieder zum WIRED-AND-Schaltglied verbunden werden. Ebenso fällt der Aufwand für die Steuerlogik, die z.B. durch einen Zähler realisiert sein soll, mit ca. einem Transistor pro zu prüfendem Signal recht gering aus, wenn z.B. zwanzig Testschaltungen aus FIG 1 parallel mit einer Steuerlogik verbunden sind. Im Vergleich zur Scan Path-Methode, die pro zu prüfendem Signal einen Multiplexer mit ca. zehn Transistoren benötigt, wird ungefähr nur die Hälfte der Transistoren pro zu prüfendem Signal verwendet.

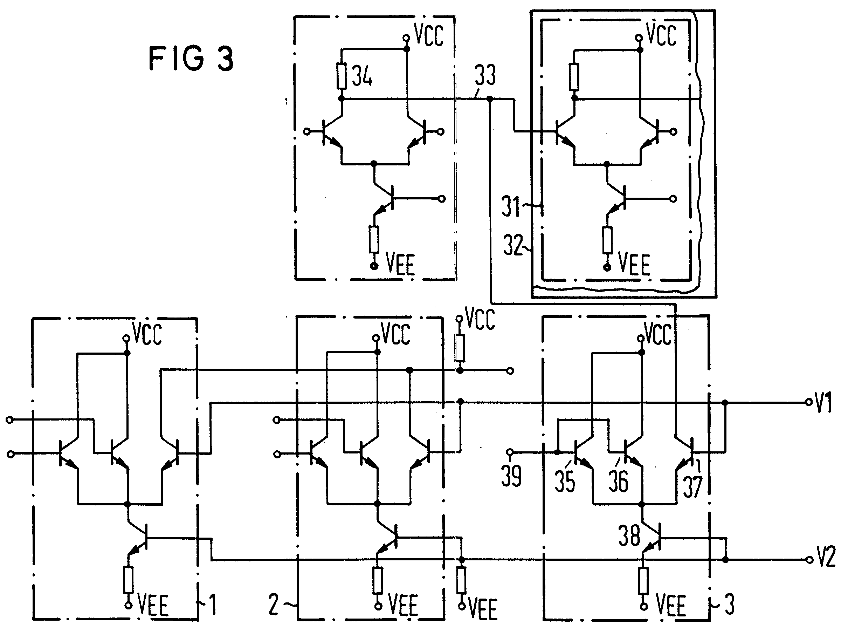

Beim Test von integrierten Digitalschaltungen tritt oft das Problem auf, zu einem bestimmten Zeitpunkt bistabile Kippstufen auf einen definierten logischen Wert, beispielsweise auf L-Potential zu setzen. FIG 3 zeigt hierzu ein weiteres Ausführungsbeispiel. Die zu prüfende integrierte Digitalschaltung sei in CML-(Current Mode Logic)Schaltungstechnik aufgebaut und enthalte eine bistabile Kippstufe. Der Inverter 31 stellt das Schaltelement am Eingang der bistabilen Kippstufe dar, der Inverter 30 gehöre beispielsweise zum Ausgang einer Funktionseinheit, die der bistabilen Kippstufe vorgeschaltet ist. Der Kollektor des Transistors 37 des ODER-Schaltgliedes 3 ist nun statt mit der WIRED-AND-Schaltung aus FIG 2 mit dem Eingang 33 der bistabilen Kippstufe verbunden. Die Basisanschlüsse der Transistoren 35 und 36 sind miteinander verbunden und bilden den Auswahlsignaleingang 39 des ODER-Schaltgliedes 3. Weiterhin sind die Basisanschlüsse der Transistoren 37, 38 wie in FIG 2 beschrieben mit den anderen ODER-Schaltgliedern 2, 3 verbunden. Durch einen L-Pegel des Auswahlsignals am Eingang 39 werden die Transistoren 35, 36 gesperrt, der Transistor 37 wird leitend. Dies bewirkt einen Spannungsabfall am Widerstand 34 des Inverters 30 und legt den Eingang 33 der bistabilen Kippstufe auf L-Potential. Somit wird eine in das Flip-Flop integrierte Rücksetzlogik, soweit sie nur für den Test der Schaltung gebraucht würde, unnötig.

## Patentansprüche

1. Schaltungsanordnung zum Testen von Funktionseinheiten in digitalen integrierten Schaltungen durch Prüfsignale mit folgenden Merkmalen:
- die Ausgänge eines oder mehrerer ODER-Schaltglieder (1,2) sind mit den Eingängen eines UND-Schaltgliedes (4) verbunden,
- ein oder mehrere Eingänge der ODER-Schaltglieder (1,2) werden mit den zu prüfenden Signalen belegt,
- ein oder mehrere weitere Eingänge der ODER-Schaltglieder (1,2) werden mit Auswahlsignalen belegt,
- das Ausgangssignal des UND-Schaltgliedes (4) wird an einen Ausgang der integrierten Schaltung geführt,
**dadurch gekennzeichnet,**
daß
- das ODER-Schaltglied mindestens drei emittergekoppelte Transistoren (10, 11, 12) enthält,
- die Emitter der ersten drei Transistoren (10, 11, 12) mit den Kollektoren eines vierten Transistors (13) verbunden sind und dessen Emitter über einen Widerstand (14) an einen Anschluß einer ersten Versorgungsspannungsquelle (VEE) angeschlossen ist,
- die Kollektoren der ersten zwei Transistoren (10, 11) mit einem Anschluß einer zweiten Versorgungsspannungsquelle (VCC) verbunden sind,
- die Basisanschlüsse der ersten zwei Transistoren (10, 11) die Eingänge des ODER-Schaltgliedes und der Kollektor des dritten Transistors (12) den Ausgang des ODER-Schaltgliedes bilden.

2. Schaltungsanordnung nach Anspruch 1,
**dadurch gekennzeichnet,**
daß
- das UND-Schaltglied dadurch gebildet wird, daß die Kollektoren der dritten Transistoren der ODER-Schaltglieder gemeinsam über einen Widerstand (16) mit einem Anschluß der zweiten Versorgungsspannungsquelle (VCC) verbunden sind,
- die Basisanschlüsse der dritten Transistoren der ODER-Schaltglieder gemeinsam mit einem Anschluß einer dritten Versorgungsspannungsquelle (V1) verbunden sind und
- die Basisanschlüsse der vierten Transistoren der ODER-Schaltglieder gemeinsam mit einem Anschluß einer vierten Versorgungsspannungsquelle (V2) und gemeinsam über einen Widerstand (20) mit einem Anschluß der ersten Versorgungsspannungsquelle (VEE) verbunden sind.

3. Schaltungsanordnung nach einem der Ansprüche 1 oder 2 zum Prüfen von bistabilen Kippstufen in einer integrierten Digital schaltung,
**dadurch gekennzeichnet,**
daß ein weiteres ODER-Schaltglied vorhanden ist,
- bei dem der Kollektor des dritten Transistors (37) mit dem Eingang einer oder mehrerer der bistabilen Kippstufen verbunden ist,
- die Basis des dritten Transistors (37) mit den Basisanschlüssen der anderen dritten Transistoren verbunden ist und
- die Basis des vierten Transistors (38) mit den Basisanschlüssen der anderen vierten Transistoren verbunden ist.

## Claims

1. Circuit arrangement for testing functional units in digital integrated circuits by means of test signals, having the following features:
- the outputs of one or more OR switching elements (1, 2) are connected to the inputs of an AND switching element (4),
- one or more inputs of the OR switching elements (1, 2) are assigned the signals to be tested,
- one or more further inputs of the OR switching elements (1, 2) are assigned selection signals,
- the output signal of the AND switching element (4) is routed to an output of the integrated circuit,
characterized in that
- the OR switching element contains at least three emitter-coupled transistors (10, 11, 12),
- the emitters of the first three transistors (10, 11, 12) are connected to the collectors of a fourth transistor (13) and the emitter of the latter is connected via a resistor (14) to a terminal of a first supply voltage source (VEE),
- the collectors of the first two transistors (10, 11) are connected to a terminal of a second supply voltage source (VCC),
- the base terminals of the first two transistors (10, 11) form the inputs of the OR switching element and the collector of the third transistor (12) forms the output of the OR switching element.

2. Circuit arrangement according to Claim 1,
characterized in that
- the AND switching element is formed by connecting the collectors of the third transistors of the OR switching elements jointly via a resistor (16) to a terminal of the second supply voltage source (VCC),
- the base terminals of the third transistors of the OR switching elements are jointly connected to a terminal of a third supply voltage source (V1), and
- the base terminals of the fourth transistors of the OR switching elements are jointly connected to a terminal of a fourth supply voltage source (V2) and are connected jointly via a resistor (20) to a terminal of the first supply voltage source (VEE).

3. Circuit arrangement according to either of Claims 1 and 2 for testing bistable multivibrators in an integrated digital circuit,
characterized in that a further OR switching element is present,
- in which the collector of the third transistor (37) is connected to the input of one or more of the bistable multivibrators,
- the base of the third transistor (37) is connected to the base terminals of the other third transistors, and
- the base of the fourth transistor (38) is connected to the base terminals of the other fourth transistors.

## Revendications

1. Agencement de circuit pour le test d'unités fonctionnelles dans des circuits intégrés numériques au moyen de signaux de test, présentant les caractéristiques suivantes
- les sorties d'un ou plusieurs éléments logiques OU (1, 2) sont reliées aux entrées d'un élément logique ET (4),
- une ou plusieurs entrées des éléments logiques OU (1, 2) sont occupées par les signaux à tester,
- une ou plusieurs autres entrées des éléments logiques OU (1, 2) sont occupées par des signaux de sélection,
- le signal de sortie de l'élément logique ET (4) est amené à une sortie du circuit intégré,
caractérisé en ce que
- l'élément logique OU comporte au moins trois transistors à émetteurs couplés (10, 11, 12),
- les émetteurs des trois premiers transistors (10, 11, 12) sont reliés aux collecteurs d'un quatrième transistor (13) et son émetteur est raccordé au moyen d'une résistance (14) à une borne d'une première source de tension d'alimentation (VEE),
- les collecteurs des deux premiers transistors (10, 11) sont reliés à une borne d'une deuxième source de tension d'alimentation (VCC),
- les bornes des bases des deux premiers transistors (10, 11) forment les entrées de l'élément logique OU et le collecteur du troisième transistor (12) la sortie de l'élément logique OU.

2. Agencement de circuit selon la revendication 1,
caractérisé en ce que
- l'élément logique ET est formé de manière à ce que les collecteurs des troisièmes transistors des éléments logiques OU soient reliés ensemble au moyen d'une résistance (16) à une borne de la deuxième source de tension d'alimentation (VCC),
- les bornes des bases des troisièmes transistors des éléments logiques OU sont reliées ensemble à une borne d'une troisième source de tension d'alimentation (V1) et
- les bornes des bases des quatrièmes transistors des éléments logiques OU sont reliées ensemble à une borne d'une quatrième source de tension d'alimentation (V2) et ensemble au moyen d'une résistance (20) à une borne de la première source de tension d'alimentation (VEE).

3. Agencement selon l'une des revendications 1 ou 2 pour le test d'étages à bascules bistables dans un circuit numérique intégré,
caractérisé en ce qu'il
existe un autre élément logique OU,
- dans lequel le collecteur du troisième transistor (37) est relié à l'entrée d'un ou plusieurs étages à bascules bistables,
- la base du troisième transistor (37) est reliée aux bornes des bases des autres troisièmes transistors et
- la base du quatrième transistor (38) est reliée aux bornes des bases des autres quatrièmes transistors.
